# EUROPÄISCHE PATENTSCHRIFT

(11) **EP 0 389 942 B1**
(45) Veröffentlichungstag und Bekanntmachung des Hinweises auf die Patenterteilung: **17.08.1994**
(21) Anmeldenummer: 90105297.7
(22) Anmeldetag: 21.03.1990
(51) Int. Cl.: H01L 29/08, H01L 29/74, H01L 29/52

(54) **Hochsperrendes Halbleiterbauelement**
High blocking voltage semiconductor device
Dispositif semi-conducteur à tension de blocage élevée

(30) Priorität: 29.03.1989 CH 1141/89
(43) Veröffentlichungstag der Anmeldung: 03.10.1990
(73) Patentinhaber: ASEA BROWN BOVERI AG, 5400 Baden (CH)
(72) Erfinder: Roggwiller, Peter, Dr., CH-8173 Riedt-Neerach (CH)

(56) Entgegenhaltungen:
- EP-A- 0 118 336
- EP-A- 0 200 863
- EP-A- 0 228 107
- EP-A- 0 280 535

## Beschreibung

### TECHNISCHES GEBIET

Die vorliegende Erfindung bezieht sich auf das Gebiet der Leistungselektronik. Sie betrifft insbesondere ein hochsperrendes Halbleiterbauelement, umfassend
(a) ein Halbleitersubstrat;
(b) in dem Halbleitersubstrat zwischen einer ersten Hauptfläche, welche einer Kathode zugeordnet ist, und einer zweiten Hauptfläche, welche einer Anode zugeordnet ist, eine Folge von unterschiedlich dotierten Schichten mit einer p-Basisschicht, in welche die Kathode bildende n-Emitterzonen eingelassen sind, einer n-Basisschicht, einer Mehrzahl von anodenseitigen p-Emitterzonen und einer zwischen n-Basisschicht und p-Emitterzonen angeordneten Stoppschicht, wobei die anodenseitige Hauptfläche des Halbleitersubstrats mit einer Anoden metallisierung bedeckt ist;
(c) eine Gateelektrode, welche durch an die kathodenseitige Hauptfläche dringende Gebiete der p-Basisschicht gebildet wird; und
(d) eine Mehrzahl von Emitterkurzschlüssen mit Kurzschlusskontaktzonen, welche zwischen den p-Emitterzonen angeordnet sind.

Ein solches Bauelement ist z.B. aus dem Artikel von T. Ogura et al. "6000 V Gate Turn-Off Thyristor with n-Buffer and new Anode Short Structure", 19th Conference on Solid State Device and Materials, Tokyo 1987, bekannt.

### STAND DER TECHNIK

Damit ein Halbleiterbauelement mit einem sperrenden PN-Uebergang in der Lage ist, hohe Spannungen zu blockieren, ist eine entsprechende Dimensionierung bezüglich der Dicke und dem spezifischen Widerstand der niedriger dotierten Schicht erforderlich.

Diese Dimensionierung richtet sich nach den zwei grundsätzlichen Kriterien, dass einerseits die am PN-Uebergang auftretende, maximale elektrische Feldstärke einen gegebenen Wert nicht übersteigt, und andererseits das elektrische Feld die beiden Hauptoberflächen des Bauelements nicht erreicht. Bei asymmetrischen Strukturen mit konstanter Dotierung der höherohmigen Schicht führt dies zu Bauelementen mit sehr grosser Dicke und entsprechend hohem Durchlasswiderstand.

Ein Ausweg aus dieser ungünstigen Situation wurde schon vor längerer Zeit darin gefunden, dass die niedrig dotierte Schicht an ihrem Ende durch eine zusätzliche, gleichnamig aber höher dotierte Schicht (Stoppschicht) abgeschlossen wird. Hierdurch wird die elektrische Feldstärke erst unmittelbar vor Erreichen der Oberfläche abgebaut, womit sich die erforderliche Dicke des Bauelements bei vorgegebener Blockierspannung etwa halbiert.

Grundsätzlich ist die Stoppschichtstruktur auch für abschaltbare Bauelemente wie GTOs geeignet, um deren Dicke zu reduzieren und damit geringere Schalt- und Durchlassverluste zu erreichen. Häufig sind aber diese Bauelemente anodenseitig mit sogenannten Emitterkurzschlüssen versehen, welche in Kombination mit einer Feldbegrenzungsschicht (Stoppschicht) zu einer massiven Verschlechterung der Zündeigenschaften führen.

Der Grund dafür liegt darin, dass die erhöhte Leitfähigkeit infolge der höher dotierten Stoppschicht unmittelbar vor dem anodenseitigen Emitter zu einer starken Verringerung des Emitterwirkungsgrades führt. Ein grosser Elektronenstrom wird bei Spannungen, welche unter dem Injektionspotential der Anode liegen, direkt zum äusseren Kontakt geleitet.

Um diesen Effekt auf ein für die Zündempfindlichkeit erträgliches Mass zu reduzieren, müssen entweder die lateralen Abstände zwischen den Anodenkurzschlüssen sehr gross oder der relative Flächenanteil sehr klein gemacht werden. In beiden Fällen verliert man einen grossen Teil der für ein verlustarmes Abschaltverhalten notwendigen Wirkung der Kurzschlüsse. Eine Variante, die beispielsweise kleinflächige, zylindrische Anodenkurzschlüsse in Kombination mit einer Stoppschicht für einen 6kV-GTO vorsieht, wird in dem eingangs genannten Artikel von T. Ogura et al. beschrieben.

Eine andere bekannte Anodenstruktur verzichtet vollständig auf Emitterkurzschlüsse, besitzt aber eine so hoch dotierte Stoppschicht, dass damit der Emitterwirkungsgrad auf das für ein gutes Schaltverhalten notwendige Mass reduziert werden kann. Der Nachteil dieses Konzepts besteht aber darin, dass es auf eine besonders gute Homogenität in der Dotierung über die ganze aktive Bauelementfläche angewiesen ist, da es andernfalls zu einer ungleichmässigen Stromverteilung während des Abschaltvorganges kommt, was offenbar eines der grössten Probleme bei abschaltbaren Leistungsbauelementen darstellt.

### DARSTELLUNG DER ERFINDUNG

Aufgabe der vorliegenden Erfindung ist es daher, ein hochsperrendes Halbleiterbauelement zu schaffen, das die Vorteile einer Kombination von Stoppschicht und Emitterkurzschlüssen ausnutzt, ohne die Nachteile der bekannten Lösungen aufzuweisen.

Die Aufgabe wird bei einem Bauelement der eingangs genannten Art dadurch gelöst, dass
(e) die Stoppschicht in Form einzelner Stoppschichtgebiete nur jeweils die p-Emitterzonen umschliesst, während die Kurzschlusskontaktzonen vollständig in die n-Basisschicht eingelassen sind; sodass
(f) zwischen jeder Kurzschlusskontaktzone und jedem Stoppschichtgebiet ein Zwischengebiet vorhanden ist, in welchem die n-Basisschicht an die anodenseitige Oberfläche des Halbleitersubstrats tritt.

Der Kern der Erfindung lässt sich wie folgt erklären: Die Wirksamkeit von Emitterkurzschlüssen ist bekanntlich dadurch bestimmt, wie stark die Vorwärtspolung des Emitterüberganges, hervorgerufen durch den über den Kurzschluss zum äusseren Kontakt fliessenden Strom, ist. Dieser Spannungsabfall ist gering und damit die Kurzschlusswirkung gross, wenn der elektrische Widerstand des Kurzschlusspfades (Kurzschlusswiderstand) klein ist, was gerade durch den Einbau einer Stoppschicht in unerwünschtem Masse bewirkt wird.

Um diesen Widerstand nicht nur zu erhöhen, sondern auch seinen Wert gezielt einzustellen, wird gemäss der Erfindung die Stoppschicht nicht ganzflächig, sondern nur lokal vor den anodenseitigen p-Emitterzonen angebracht. In diesem Bereich verhindert diese zusätzliche Dotierung, dass das elektrische Feld im Blockierfall bis zum Emitter vorstossen und Injektion auslösen kann.

Die übrigen Bereiche bestehen entweder aus den hochdotierten Kurzschlusskontaktzonen bzw. den schwach dotierten Zwischengebieten der n-Basisschicht. Erstere stellen für das elektrische Feld eine sehr harte Begrenzung dar, während dieses im Zwischenbereich bis an die Bauelementoberfläche vorstossen kann.

Gemäss einem bevorzugten Ausführungsbeispiel der Erfindung ist
(a) die anodenseitige Oberfläche des Halbleitersubstrats mit einer Anodenmetallisierung bedeckt; und
(b) zur elektrischen Trennung von n-Basisschicht und Anodenmetallisierung das Halbleitersubstrat anodenseitig im Bereich jedes Zwischengebietes mit einer Isolierschicht bedeckt und/oder die Anodenmetallisierung im Bereich der Zwischengebiete ausgespart.

Die Isolierschicht zwischen der Anodenmetallisierung und dem Halbleitersubstrat verhindert, dass im Bereich der Zwischengebiete Ströme direkt zum metallischen Kontakt fliessen können. Die an dieser Stelle auftretenden Feldstärken können zwar noch beträchtlich sein, liegen aber mit weniger als ca. 10⁵ V/cm weit unter der Durchbruchfeldstärke von beispielsweise SiO₂ mit mehr als 10⁶ V/cm.

In der erfindungsgemässen Struktur ist der Kurzschlusswiderstand im wesentlichen durch den Abstand d zwischen dem lokalen Stoppschichtgebiet und der n⁺-Kurzschlusskontaktzone sowie den spezifischen Widerstand der schwach dotierten Seite des PN-Uebergangs bestimmt. Damit ergibt sich die Möglichkeit, über eine leicht zu kontrollierende, geometrische Grösse diesen Widerstand und damit die Kurzschlusswirkung einzustellen.

Weitere Ausführungsbeispiele ergeben sich aus den Unteransprüchen.

### KURZE BESCHREIBUNG DER ZEICHNUNG

Die Erfindung soll nachfolgend anhand von Ausführungsbeispielen im Zusammenhang mit der Zeichnung näher erläutert werden. Es zeigen
- Fig.1: den Schnitt durch einen GTO mit Stoppschicht und Emitterkurzschlüssen nach dem Stand der Technik;
- Fig.2: im Schnitt die entsprechende Anodenstruktur eines GTO gemäss einem bevorzugten Ausführungsbeispiel der Erfindung;
- Fig.3A: die berechnete Feldverteilung in einer Struktur gemäss Fig.2; und
- Fig.3B: die berechnete Potentialverteilung in einer Struktur gemäss Fig.2.

### WEGE ZUR AUSFÜHRUNG DER ERFINDUNG

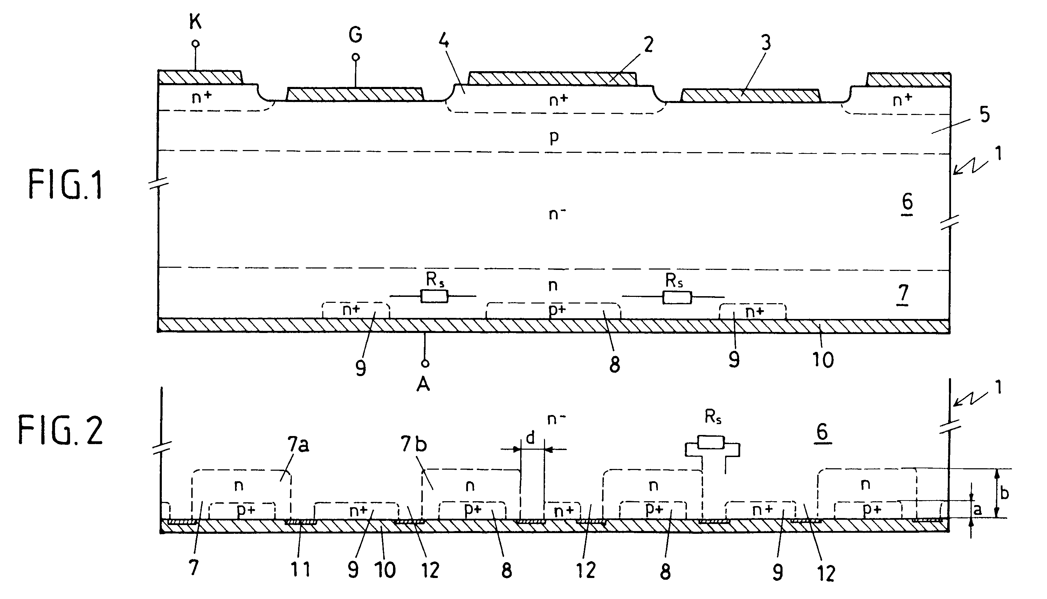

Zur Erläuterung der Erfindung wird nachfolgend das Beispiel eines über ein Gate abschaltbaren Thyristors (GTO) gewählt. Ein solcher GTO, der mit einer Stoppschicht und Emitterkurzschlüssen ausgestattet ist, hat im Stand der Technik die in Fig.1 dargestellte Struktur.

Der beispielhafte GTO umfasst ein grossflächiges Halbleitersubstrat 1, das auf der einen (unteren) Hauptoberfläche mit einer Anodenmetallisierung 10 und auf der anderen (oberen) Hauptoberfläche mit Gatemetallisierungen 3 und Kathodenmetallisierungen 2 versehen ist. Den Metallisierungen 2, 3 und 10 entsprechen als äussere Anschlüsse eine Kathode K, ein Gate G und eine Anode A.

Im Halbleitersubstrat 1 ist zwischen der Kathode K und der Anode A eine Folge von unterschiedlich dotierten Schichten angeordnet, die n⁺-dotierte n-Emitterzonen 4, eine p-dotierte p-Basisschicht 5, eine n⁻-dotierte n-Basisschicht 6, eine n-dotierte Stoppschicht 7 sowie innerhalb dieser Stoppschicht 7 p⁺-dotierte p-Emitterzonen 8 und n⁺-dotierte Kurzschlusskontaktzonen 9 umfasst.

Zwischen den p-Emitterzonen 8 und den Kurzschlusskontaktzonen 9 verlaufen jeweils die Kurzschlusspfade, die durch einen Kurzschlusswiderstand Rₛ (in Fig.1 schematisch dargestellt) charakterisiert sind. Da die Kurzschlusspfade vollständig in der höher n-dotierten Stoppschicht 7 verlaufen, ist der Kurzschlusswiderstand Rₛ vergleichsweise klein und die Kurzschlusswirkung entsprechend gross. Dies hat zur Folge, dass der Emitterwirkungsgrad der p-Emitterzonen 8 und damit die Zündempfindlichkeit des Bauelements erheblich abnehmen.

Um die Feldbegrenzungswirkung der Stoppschicht ohne Verringerung des Emitterwirkungsgrades zu erhalten wird gemäss der Erfindung die durchgehende Stoppschicht durch lokal begrenzte Stoppschichtgebiete ersetzt. Dies führt zu einer anodenseitigen Bauelementkonfiguration, wie sie im Ausführungsbeispiel der Fig.2 dargestellt ist.

Die Stoppschicht 7 besteht dort aus den einzelnen Stoppschichtgebieten 7a,b, die jeweils die p-Emitterzonen 8, nicht aber die Kurzschlusskontaktzonen 9 umschliessen. Auf diese Weise entstehen zwischen den Stoppschichtgebieten 7a,b und den Kurzschlusskontaktzonen 9 Zwischengebiete 12 mit der niedrigen n⁻-Dotierung der n-Basisschicht 6.

Der Kurzschlusswiderstand Rₛ wird dann massgeblich durch den lateralen Abstand d von Stoppschichtgebiet 7a,b und Kurzschlusskontaktzone 9 und den relativ hohen spezifischen Widerstand der n-Basisschicht bestimmt. Man erreicht so nicht nur günstige Widerstandsverhältnisse in den Kurzschlusspfaden, sondern kann auch auf einfache Weise den Kurzschlusswiderstand Rₛ über die Wahl des Abstandes d in weiten Grenzen einstellen.

Der hohe spezifische Widerstand der n-Basisschicht 6 kommt im Kurzschlusspfad allerdings nur dann voll zum Tragen, wenn in den Zwischengebieten 12 die Oberfläche des Halbleitersubstrats 1 von der Anodenmetallisierung 10 durch entsprechende Isolierschichten 11 elektrisch getrennt wird, die beispielsweise aus SiO₂ bestehen. Alternativ oder zusätzlich zu den Isolierschichten 11 kann in den Bereichen der Zwischengebiete 12 auch lokal die Anodenmetallisierung 10 ausgespart werden.

Die Kurzschlusskontaktzonen 9 und die p-Emitterzonen 8 werden vorzugsweise mit einer Tiefe von etwa 20 µm in das Halbleitersubstrat 1 eingelassen. Für die Stoppschichtgebiete 7a,b wird eine Tiefe b von etwa 50 µm bevorzugt. Die Dotierungskonzentration an der Oberfläche der Stoppschichtgebiete 7a,b liegt dabei vorzugsweise bei etwa 10¹⁶ cm⁻³, während sich ein spezifischer Widerstand der n-Basisschicht 6 von 500 Ωcm bewährt hat.

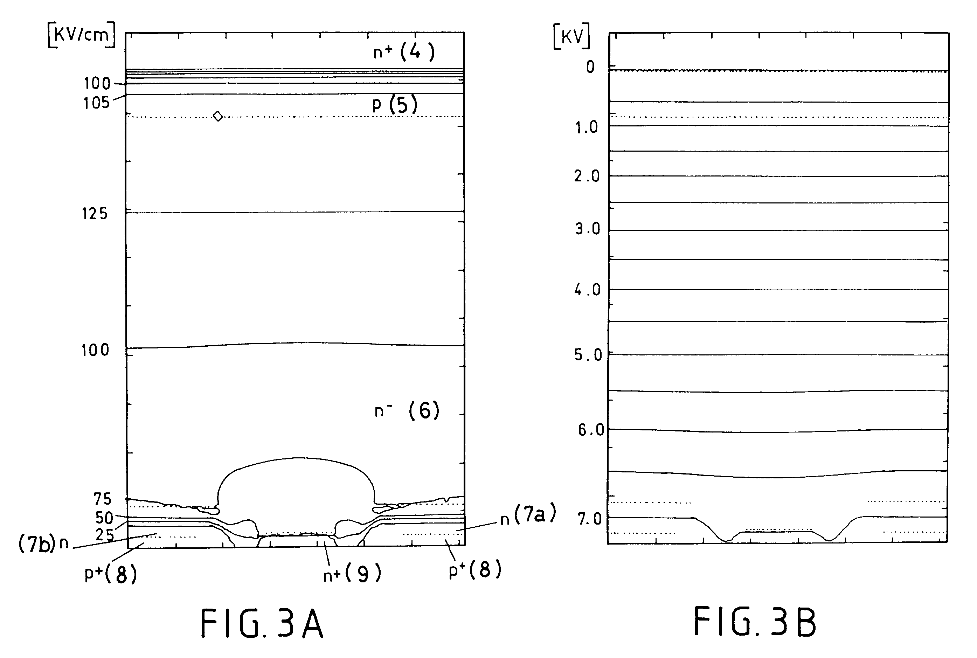

Unter Zugrundelegung einer Anodenstruktur gemäss Fig. 2 mit den oben angegebenen bevorzugten Parameterwerten wurde das Blockierverhalten eines GTO bei einer Spannung von 7 kV berechnet. Die resultierenden Verteilungen des elektrischen Feldes und des Potentials sind in den Fig.3A bzw. 3B wiedergegeben (die Skalenteilung beträgt in beiden Figuren horizontal und vertikal 70 µm/Teilstrich).

Man erkennt aus den Fig.3A und B sofort, dass die Hauptaufgabe der feldbegrenzenden Stoppschichtgebiete 7a,b, nämlich das Durchgreifen des Feldes bis zu den p-Emitterzonen 9 zu verhindern, erfüllt ist.

Für die Produktion von hochsperrenden Bauelementen stellt die vorgeschlagene Anodenstruktur keine zusätzliche Schwierigkeit dar. Die notwendige Maskierung bei der Dotierstoffbelegung für die Stoppschichtgebiete 7a,b lässt sich leicht in jeden Prozessablauf integrieren.

Einzig die Isolierschichten 11 müssen auf der ganzen aktiven Fläche fehlerfrei sein. Fehler können dann toleriert werden, wenn zusätzlich in diesen Bereichen die Anodenmetallisierung 10 ausgespart wird.

Obgleich die Erfindung hier am Beispiel eines GTO erläutert worden ist, kann sie auch auf andere hochsperrende Bauelemente angewandt werden, bei denen eine Kombination aus Stoppschicht und Emitterkurzschlüssen vorgesehen ist.

## Patentansprüche

1. Hochsperrendes Halbleiterbauelement, umfassend
(a) ein Halbleitersubstrat (1);
(b) in dem Halbleitersubstrat (1) zwischen einer ersten Hauptfläche, welche einer Kathode (K) zugeordnet ist, und einer zweiten Hauptfläche, welche einer Anode (A) zugeordnet ist, eine Folge von unterschiedlich dotierten Schichten mit einer p-Basisschicht (5), in welche die Kathode (K) bildende n-Emitterzonen (4) eingelassen sind, einer n-Basisschicht (6), einer Mehrzahl von anodenseitigen p-Emitterzonen (8) und einer zwischen der n-Basisschicht (6) und den p-Emitterzonen (8) angeordneten Stoppschicht (7), wobei die anodenseitige Hauptfläche des Halbleitersubstrats (1) mit einer Anodenmetallisierung (10) bedeckt ist;
(c) eine Gateelektrode (G), welche durch an die kathodenseitige Hauptfläche dringende Gebiete der p-Basisschicht (5) gebildet wird; und
(d) eine Mehrzahl von anodenseitigen Emitterkurzschlüssen mit Kurzschlusskontaktzonen (9), welche zwischen den p-Emitterzonen (8) angeordnet sind;
dadurch gekennzeichnet, dass
(e) die Stoppschicht (7) in Form einzelner Stoppschichtgebiete (7a,b) nur jeweils die p-Emitterzonen (8) umschliesst, während die Kurzschlusskontaktzonen (9) vollständig in die n-Basisschicht (6) eingelassen sind; sodass
(f) zwischen jeder Kurzschlusskontaktzone (9) und jedem Stoppschichtgebiet (7a,b) ein Zwischengebiet (12) vorhanden ist, in welchem die n-Basisschicht (6) an die anodenseitige Hauptfläche des Halbleitersubstrats (1) tritt.

2. Bauelement nach Anspruch 1, dadurch gekennzeichnet, dass zur elektrischen Trennung von n-Basisschicht (6) und Anodenmetallisierung (10) das Halbleitersubstrat (1) anodenseitig im Bereich jedes Zwischengebietes (12) mit einer Isolierschicht (11) bedeckt und/oder die Anodenmetallisierung (10) im Bereich der Zwischengebiete (12) ausgespart ist.

3. Bauelement nach Anspruch 2, dadurch gekennzeichnet, dass die Folge von unterschiedlich dotierten Schichten der eines über ein Gate (G) abschaltbaren Thyristors GTO entspricht.

4. Bauelement nach Anspruch 3, dadurch gekennzeichnet, dass
(a) die Stoppschichtgebiete (7a,b) eine Dotierungskonzentration an der Oberfläche von etwa 10¹⁶ cm⁻³ aufweisen;
(b) die Kurzschlusskontaktzonen (9) und p-Emitterzonen (8) bis zu einer Tiefe (a) von etwa 20 µm; und
(c) die Stoppschichtgebiete (7a,b) bis zu einer Tiefe (b) von etwa 50 µm in das Halbleitersubstrat (1) eingelassen sind.

5. Bauelement nach Anspruch 3, dadurch gekennzeichnet, dass der spezifische Widerstand der n-Basisschicht (6) etwa 500 Ωcm beträgt.

## Claims

1. High blocking-capacity semiconductor component, comprising
(a) a semiconductor substrate (1);
(b) in the semiconductor substrate (1), between a first main surface which is assigned to a cathode (K), and a second main surface which is assigned to an anode (A), a series of differently doped layers with a p-type base layer (5) into which the cathode (K)-forming n-type emitter zones (4) have been incorporated, an n-type base layer (6), a plurality of anode-side p-type emitter regions (8) and a barrier layer (7) arranged between the n-type base layer (6) and the p-type emitter regions (8), the anode-side main surface of the semiconductor substrate (1) being covered by an anode metallization (10);
(c) a gate electrode (G), which is formed by regions of the p-type base layer (5) which penetrates to the cathode-side main surface; and
(d) a plurality of anode-side emitter short-circuits with short-circuit contact regions (9), which are arranged between the p-type emitter regions (8);
characterized in that
(e) the barrier layer (7) in the form of separate barrier-layer regions (7a,b) only surrounds each of the p-type emitter regions (8), while the short-circuit contact regions (9) are completely set into the n-type base layer (6); so that
(f) between each short-circuit contact region (9) and each barrier-layer region (7a,b) an intermediate region (12) is present, in which the n-type base layer (6) meets the anode-side main surface of the semiconductor substrate (1).

2. Component according to Claim 1, characterized in that for electrical isolation from the n-type base layer (6) and anode metallization (10) the semiconductor substrate (1) is covered on the anode side around each intermediate region (12) with an insulating layer (11), and/or the anode metallization (10) around the intermediate regions (12) is omitted.

3. Component according to Claim 2, characterized in that the series of differently doped layers corresponds to that of a gate (G) turn-off thyristor (GTO).

4. Component according to Claim 3, characterized in that
(a) the barrier-layer regions (7a,b) exhibit a doping concentration at the surface of about 10¹⁶ cm⁻³;
(b) the short-circuit contact regions (9) and p-type emitter regions (8) are set into the semiconductor substrate (1) to a depth (a) of about 20 µm; and
(c) the barrier-layer regions (7a,b) are set into the semiconductor substrate (1) to a depth (b) of about 50 µm.

5. Component according to Claim 3, characterized in that the specific resistance of the n-type base layer (6) has a value of about 500 Ohm cm.

## Revendications

1. Composant semi-conducteur à capacité de blocage d'arrêt élevée comprenant :
a) un substrat semi-conducteur (1),
b) dans le substrat semi-conducteur (1), entre une première face principale qui est affectée à une cathode (K) et une deuxième face principale qui est affectée à une anode (A), une succession de couches dopées différemment avec une couche de base p (5) dans laquelle sont incorporées des zones d'émetteur n (4) formant la cathode (K), une couche de base n (6), une pluralité de zones d'émetteur p côté anode (8) et une couche de barrage (7) disposée entre la couche de base n (6) et les zones d'émetteur p (8), la face principale côté anode du substrat semi-conducteur (1) étant recouverte d'une métallisation d'anode (10);
c) une gâchette (G) formée par des régions de la couche de base p (5) pénétrant la face principale côté cathode, et
d) une pluralité de courts-circuits d'émetteur côté anode avec des zones de contact de court-circuit (9) qui sont disposées entre les zones d'émetteur p (8);
caractérisé en ce que :
e) la couche de barrage, (7) sous la forme de régions individuelles de couche de barrage (7a, b), n'enserre que les zones d'émetteur p (8) respectives, tandis que les zones de contact de court-circuit (9) sont complètement incorporées dans la couche de base n (6); de sorte que
f) entre chaque zone de contact de court-circuit (9) et chaque région de la couche de barrage (7a, b), il existe une région intermédiaire dans laquelle la couche de base n (6) apparaît à la face principale côté anode du substrat semi-conducteur (1).

2. Composant selon la revendication 1, caractérisé en ce que, pour la séparation électrique de la couche de base n (6) et de la métallisation d'anode (10), le substrat semi-conducteur (1) est recouvert du côté anode, à proximité de chaque région intermédiaire (12), d'une couche d'isolation (11) et/ou la métallisation d'anode (10) est éliminée à proximité des régions intermédiaires (12).

3. Composant selon la revendication 2, caractérisé en ce que la succession de couches dopées différemment correspond à celle d'un thyristor GTO interruptible par la gâchette (G).

4. Composant selon la revendication 3, caractérisé en ce que
(a) les régions de la couche de barrage (7a, b) présentent une concentration de dopage, à la surface, d'environ 10¹⁶ cm⁻³;
(b) les zones de contact de court-circuit (9) et les zones d'émetteur p (8) sont incorporées dans le substrat semi-conducteur (1) jusqu'à une profondeur (a) d'environ 20µm; et
(c) les régions de la couche de barrage (7a, b) sont incorporées dans le substrat semi-conducteur (1) jusqu'à une profondeur (b) d'environ 50µm.

5. Composant selon la revendication 3, caractérisé en ce que la résistance spécifique de la couche de base n (6) est d'environ 500 Ωcm.
